# EUROPEAN PATENT APPLICATION

(11) **EP 4 206 802 A1**
(43) Date of publication of application: **05.07.2023**
(21) Application number: 21943457.8
(22) Date of filing: 31.05.2021
(51) Int. Cl.: G02F 1/1333, H01L 51/50

(54) **DISPLAY APPARATUS, AND DISPLAY MODULE AND MANUFACTURING METHOD THEREFOR**

(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: ZHANG, Jiaqin, Beijing 100176 (CN); LU, Xu, Beijing 100176 (CN); GONG, Qing, Beijing 100176 (CN)
(74) Representative: Potter Clarkson
(86) International application number: PCT/CN2021/097483
(87) International publication number: WO 2022/252081

(57) **Abstract**

A display apparatus, and a display module and a manufacturing method therefor. The display module comprises a display panel (1), a protective layer (2), a cover plate (3), and a conductive medium (4); the display panel (1) is provided with a display region (101) and a peripheral region (102) located outside the display region (101); the protective layer (2) is provided at one side of the display panel (1) and covers at least part of the peripheral region (102) and the display region (101); the protective layer (2) comprises a conductive heat dissipation layer (21); and the cover plate (3) is provided at the side of the display panel (1) distant from the protective layer (2), and is electrically connected to the heat dissipation layer (21) by means of the conductive medium (4). The display module of the present disclosure can prevent abnormal display.

## Description

### TECHNICAL FIELD

The present disclosure relates to the field of display technology, and in particular, to a display device, a display module, and a manufacturing method of the display module.

### BACKGROUND

A display module is an indispensable part of electronic equipment such as mobile phones and computers. Among them, OLED (Organic Light Emitting Diode) display modules using OLEDs as light-emitting elements are widely used. However, the current display module still has the problem of display abnormality such as color cast, which needs to be solved urgently.

It should be noted that the information disclosed in the above Background section is only for enhancement of understanding of the background of the present disclosure, and therefore may contain information that does not form the prior art that is already known to a person of ordinary skill in the art.

### SUMMARY

The purpose of the present disclosure is to provide a display device, a display module and a manufacturing method thereof.

According to an aspect of the present disclosure, there is provided a display module, including:
a display panel, having a display area and a peripheral area located outside the display area;
a protective layer, disposed on a side of the display panel, wherein the protective layer covers at least a part of the peripheral area and the display area; and the protective layer includes a conductive heat dissipation layer;
a cover plate, disposed on a side of the display panel away from the protective layer; and
a conductive medium, wherein the cover plate is electrically connected with the heat dissipation layer through the conductive medium.

In an exemplary embodiment of the present disclosure, the cover plate includes a transparent base and a conductive layer, the transparent base has a middle area and an edge area located outside the middle area; the middle area covers the display area, the edge area covers the peripheral area; the conductive layer is disposed on a surface of the transparent base away from the display panel and is electrically connected with the heat dissipation layer through the conductive medium, the conductive layer at least includes a middle wire located in the middle area.

In an exemplary embodiment of the present disclosure, the conductive layer further includes an edge wire, the edge wire is located in the edge area and is disposed around the middle area; each middle wire is connected with the edge wire, and the edge wire is connected with the heat dissipation layer.

In an exemplary embodiment of the present disclosure, a quantity of the middle wire is plural and the plurality of middle wires intersect with each other to form a grid structure.

In an exemplary embodiment of the present disclosure, the middle wires include first middle wires and second middle wires, the first middle wires extend along a row direction and are spaced apart along a column direction; the second middle wires extend along the column direction and are spaced apart along the row direction; the second middle wires intersect with the first middle wires.

In an exemplary embodiment of the present disclosure, the display area is provided with an opening, the conductive layer further includes an avoidance wire, an orthographic projection of the avoidance wire on the display panel at least partially surrounds outside the opening; the avoidance wire is connected to at least one of the middle wires.

In an exemplary embodiment of the present disclosure, the conductive medium connects the conductive layer and the heat dissipation layer across an edge of the display panel from an outer side of the edge of the display panel.

In an exemplary embodiment of the present disclosure, a boundary of the heat dissipation layer is located inside a boundary of the transparent base, the heat dissipation layer includes a main body area and a connection area located outside the main body area, the connection area is connected with the main body area;
the connection area is connected with the conductive layer through the conductive medium.

In an exemplary embodiment of the present disclosure, in a direction parallel to the main body area, a distance between a boundary of an orthographic projection of the connection area on the transparent base and the boundary of the transparent base is a first distance;
in a direction parallel to the main body area, a distance between a boundary of an orthographic projection of the main body area on the transparent base and the boundary of the transparent base is a second distance;
the first distance is smaller than the second distance.

In an exemplary embodiment of the present disclosure, the cover plate further includes:
an isolation layer, at least covering the middle wire, wherein the isolation layer is made of a transparent insulating material.

In an exemplary embodiment of the present disclosure, the edge area of the transparent base is bent toward a side close to the protective layer.

In an exemplary embodiment of the present disclosure, the protective layer further includes:
an adhesive layer, disposed on a side of the display panel away from the cover plate;
a buffer layer, adhered to a surface of the adhesive layer away from the cover plate;
a reinforcing layer, disposed on a surface of the buffer layer away from the cover plate,
wherein the heat dissipation layer is disposed on a surface of the reinforcing layer away from the cover plate.

In an exemplary embodiment of the present disclosure, an orthographic projection of the connection area on the transparent base is at least partially located in the edge area;
the display module further includes:
a light shielding layer, disposed on a surface of the transparent base close to the display panel and located in the edge area; the light shielding layer is made of a conductive material;
at least a part of the connection area is electrically connected with the light shielding layer.

In an exemplary embodiment of the present disclosure, the display panel includes:
a driving backplane;
a light-emitting layer, disposed on a side of the driving backplane away from the protective layer;
a back film, disposed on a surface of the driving backplane away from the light-emitting layer;
wherein the adhesive layer is adhered to a surface of the back film away from the light-emitting layer; a boundary of the adhesive layer is located within a boundary of the back film, and a spacer area exists between the boundary of the adhesive layer and the boundary of the back film;
the conductive layer is electrically connected with the heat dissipation layer through the conductive medium, and the conductive medium connects the conductive layer and the heat dissipation layer across an edge of the display panel from an outer side of the edge of the display panel;
the conductive medium is electrically connected with the spacer area.

In an exemplary embodiment of the present disclosure, the cover plate has a main body area and a surrounding area located outside the main body area; the main body area covers the display area, and the surrounding area covers the peripheral area, the conductive medium is connected to the surrounding area;
the conductive medium connects the cover plate and the heat dissipation layer across an edge of the display panel from an outer side of the edge of the display panel.

In an exemplary embodiment of the present disclosure, the surrounding area includes a plurality of contact areas spaced apart along a circumferential direction of the main body area, and the conductive medium is connected to the contact areas.

In an exemplary embodiment of the present disclosure, an outer peripheral surface of the cover plate is surrounded by a plurality of side surfaces distributed in a circumferential direction, and a junction between two adjacent side surfaces is a comer; any of the corners is located within one of the contact areas; the conductive medium connected to any of the contact areas covers the corner in the contact area.

According to an aspect of the present disclosure, there is provided a method for manufacturing a display module, including:
forming a display panel, wherein the display panel has a display area and a peripheral area located outside the display area;
forming a cover plate on a side of the display panel;
forming a protective layer on a side of the display panel away from the cover plate, wherein the protective layer covers at least a part of the peripheral area and the display area; the protective layer includes a conductive heat dissipation layer;
connecting the cover plate and the heat dissipation layer electrically through a conductive medium.

In an exemplary embodiment of the present disclosure, connecting the cover plate and the heat dissipation layer electrically through a conductive medium includes:
forming a conductive material connecting the heat dissipation layer across an edge of the display panel through an outer side of the edge of the display panel;
curing the conductive material to obtain the conductive medium.

According to an aspect of the present disclosure, there is provided a display device, including any of the display modules described above.

It should be noted that the above general description and the following detailed description are merely exemplary and exemplary and should not be construed as limiting of the present disclosure.

### BRIEF DESCRIPTION OF THE DRAWINGS

The accompanying drawings, which are incorporated in and constitute a part of this specification, illustrate embodiments consistent with the disclosure and serve to explain the principles of the disclosure together with the description. The drawings in the following description are only some embodiments of the present disclosure, and for those of ordinary skill in the art, other drawings can also be obtained from these drawings without creative effort.
FIG. 1 is a cross-sectional view of an embodiment of a display module of the present disclosure.
FIG. 2 is a partial cross-sectional view of an embodiment of a display module of the present disclosure.
FIG. 3 is a circuit diagram of a pixel circuit of an embodiment of the display module of the present disclosure.
FIG. 4 is a schematic diagram of a conductive layer of an embodiment of the display module of the present disclosure.
FIG. 5 is a schematic diagram of a conductive layer of another embodiment of the display module of the present disclosure.
FIG. 6 is a schematic diagram of a heat dissipation layer and a conductive medium of an embodiment of the display module of the present disclosure
FIG. 7 is a schematic diagram of a heat dissipation layer of an embodiment of the display module of the present disclosure.
FIG. 8 is a partial cross-sectional view of another embodiment of the display module of the present disclosure.
FIG. 9 is a partial cross-sectional view of yet another embodiment of a display module of the present disclosure.
FIG. 10 is a partial cross-sectional view of an embodiment of a display module of the present disclosure.
FIG. 11 is a top view of the embodiment of FIG. 10.
FIG. 12 is a cross-sectional view of an embodiment of a display device of the present disclosure.

### Description of reference numerals:

1. display panel; 101, display area; 102, peripheral area; 100, opening; 11, driving backplane; 12, light-emitting layer; 13, encapsulation layer; 14, back film; 141, spacer area;
2, protective layer; 21, heat dissipation layer; 22, adhesive layer; 23, buffer layer; 24, reinforcement layer; 211, main body area; 212, connection area;
3, cover plate; 31, transparent base; 311, middle area; 312, edge area; 32, conductive layer; 321, middle wire; 3211, first middle wire; 3212, second middle wire; 322, edge wire; 323, avoidance wire; 33, isolation layer; 301, body area; 302, surrounding area; 3021, contact area; 30, side surface; 300, comer;
4. conductive medium;
5. polarizer;
6. optical adhesive layer;
7. frame;
8. light shielding layer.

### DETAILED DESCRIPTION

Example embodiments will now be described more fully with reference to the accompanying drawings. Example embodiments, however, can be embodied in various forms and should not be construed as limited to the embodiments set forth herein; rather, these embodiments are provided so that this disclosure will be thorough and complete, and will fully convey the concept of example embodiments to those skilled in the art. The same reference numerals in the drawings denote the same or similar structures, and thus their detailed descriptions will be omitted. Furthermore, the drawings are merely schematic illustrations of the present disclosure and are not necessarily drawn to scale.

The terms "a", "an", "the", "said" and "at least one" are used to indicate the presence of one or more elements/components/etc.; the terms "including" and "having" are used to indicate an open-ended inclusive meaning and mean that additional elements/components/etc. may be present in addition to the listed elements/components/etc.; the terms "first", "second" and "third" etc. are only used as a marker, not to limit the number of the objects.

In the related art, the OLED display module includes a driving backplane and a light-emitting layer arrayed on a side of the driving backplane. The light-emitting layer may include a plurality of light-emitting elements. The display module can be divided into a display area and a peripheral area located outside the display area. The light-emitting elements are located in the display area.

The driving backplane may include a substrate and a driving circuit arranged on the substrate. The driving circuit may include a pixel circuit located in the display area and a peripheral circuit located in the peripheral area. The peripheral circuit is connected with the pixel circuit, and includes a light-emitting control circuit, a gate driving circuit and a source driving circuit, etc. The light-emitting control circuit can be used to output light-emitting control signals to the pixel circuit. The gate driving circuit can be used to output write control signals and reset control signals to the pixel circuit. The source driving circuit can be used to output data signals to the pixel circuit. In addition, the driving circuit can also be used to output the first power supply signal, the second power supply signal and the reset signal to the pixel circuit.

The light-emitting element of the light-emitting layer may be an OLED, i.e., an organic light-emitting diode, which may have a first end and a second end. The first end may be an anode, and the second end may be a cathode. The first end of the light-emitting element can be connected to the pixel circuit. The second end is used for inputting the second power supply signal.

By controlling the peripheral circuit to input the light-emitting control signal, write control signal, reset control signal, data signal, first power supply signal, second power supply signal and reset signal to the pixel circuit and the light-emitting element, the light-emitting element can emit light, to display an image.

In addition, to protect the display module, a transparent cover plate can be provided on the light-exiting side of the display module, that is, the side of the light-emitting layer away from the driving backplane. In order to ensure that the reliability of the product can meet the standard, it needs to be tested before it is put on the market. Taking the copper rod test as an example, the test process is as follows. The display module displays a static image normally, and a scribing machine or other similar equipment is used to simulate the touch-control sliding action of a human finger, continuous friction test on the surface of the cover plate lasts for a certain period of time, such as 8 hours. Before the end of the test, if the static picture has abnormal display such as color cast or black screen, the test result is failure.

After a lot of research, the inventor found that due to the different materials of the copper rod and the cover plate, their binding forces to the electrons are different. During the repeated friction process of the copper rod test, the electrons were gradually transferred from the copper rod to the surface of the cover plate, and gradually formed a local random charge accumulation. Because the cover plate is usually made of glass, it has high resistivity and high dielectric constant, and neither positive nor negative charges can move easily. When the charges locally accumulate to a certain extent, it will interfere with the driving circuit below, thus affecting the displayed image.

Specifically, the charges accumulated on the cover plate cause the overall potential of the display module to decrease, cause the potential of the substrate to decrease, which further cause the Vth (threshold voltage) of the transistor of the pixel circuit to shift. For example, negative charges can positively bias the Vth of the driving transistor, causing an abnormal increase of the drive current. However, the brightness of the light-emitting element depends on the magnitude of the drive current. The greater the drive current is, the greater the brightness of the light-emitting element will be. Therefore, the increase of the drive current relative to the predetermined drive current caused by the charge accumulation causes the local light-emitting elements to become brighter. As for red (R), green (G), and blue (B) light-emitting elements, the quantum efficiency (the efficiency of excitons transitioning into low-level electrons and releasing photons) of the light-emitting material of the green light-emitting element is the highest, the lighting is also the fastest. Therefore, when the transistors of the light-emitting elements of the three colors are equally shifted, the color of the entire screen appears greenish more, and thus there will be locally greenish.

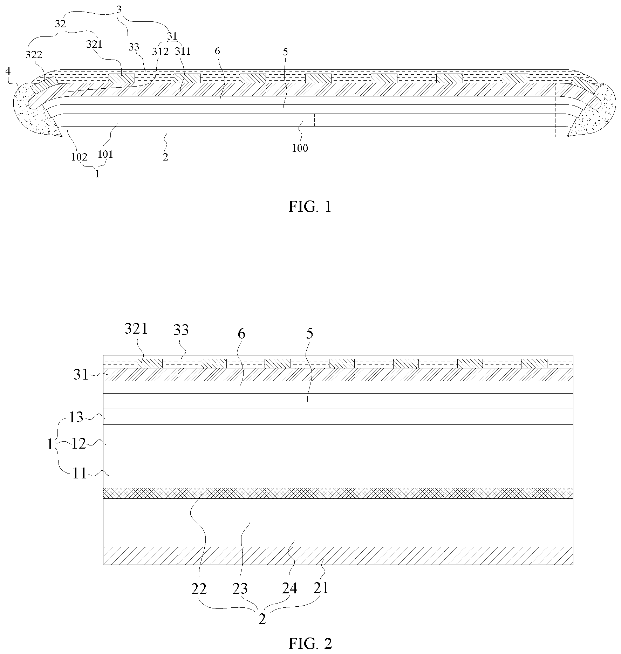

In order to solve the above problems, an embodiment of the present disclosure provides a display module, as shown in FIG. 1, FIG. 2 and FIG. 4. The display module may include a display panel 1, a protective layer 2, a cover plate 3 and a conductive medium 4.

In the embodiment, the display panel 1 has a display area 101 and a peripheral area 102 located outside the display area 101. The protective layer 2 is disposed on one side of the display panel 1, and the protective layer 2 covers at least part of the peripheral area 102 and the display area 101. The protective layer 2 includes a conductive heat dissipation layer 21. The cover plate 3 is disposed on the side of the display panel 1 away from the protective layer 2. The cover plate 3 is electrically connected to the heat dissipation layer 21 through the conductive medium 4.

In the display module of the embodiment of the present disclosure, the heat dissipation layer 21 can be grounded when in use. During the copper rod test, the charges accumulated on the cover plate 3 due to the friction of the copper rod can be channeled along the conductive medium 4 to the heat dissipation layer 21 and connected to the ground, thereby reducing the charges accumulated on the cover plate 3 and avoiding the charges to interfere with the pixel circuit, preventing color cast problems such as greenish cast and other display abnormalities caused by the accumulation of charges during testing.

The basic structure of the display module according to the embodiment of the present disclosure will be described in detail below.

As shown in FIGS. 1 and 2, the display panel 1 can be used to emit light to display images. The display panel 1 can include a driving backplane 11 and a light-emitting layer 12 located on a side of the driving backplane 11.

The driving backplane 11 may include a substrate and a driving circuit layer. The substrate is a flat plate structure, and its material may be a hard material such as glass, or a soft material such as polyimide. The driving circuit layer may be disposed on a side of the substrate and include the driving circuit. The display panel 1 can be divided into at least a display area 101 and a peripheral area 102 located outside the display area 101. Correspondingly, the driving circuit layer can include pixel circuits located at least partially in the display area 101 and peripheral circuits located in the peripheral area 102. The pixel circuit can be a pixel circuit such as 7T1C, 7T2C, 6T1C or 6T2C, as long as it can drive the light-emitting element to emit light, and its structure is not limited herein. The number of the pixel circuits is the same as that of the light-emitting elements, and the pixel circuits are connected with each light-emitting element in a one-to-one correspondence, so as to control each light-emitting element to emit light respectively. In the embodiment, nTmC indicates that a pixel circuit includes n transistors (represented by the letter "T") and m capacitors (represented by the letter "C").

The peripheral circuit is located in the peripheral area 102, and the peripheral circuit is connected to the pixel circuit, for inputting a driving signal to the pixel circuit, so as to control the light-emitting element to emit light. The peripheral circuit is connected with the pixel circuit, and includes a light-emitting control circuit, a gate driving circuit, a source driving circuit, a power supply circuit, and the like. The light-emitting control circuit can be used to output a light-emitting control signal to the pixel circuit. The gate driving circuit can be used to output a write control signal and a reset control signal to the pixel circuit. The source driving circuit can be used to output a data signal to the pixel circuit. In addition, the driving circuit can also be used to output the first power supply signal, the second power supply signal and the reset signal to the pixel circuit.

The following takes a pixel circuit with a 7T1C structure as an example to illustrate the structure and driving method of the pixel circuit.

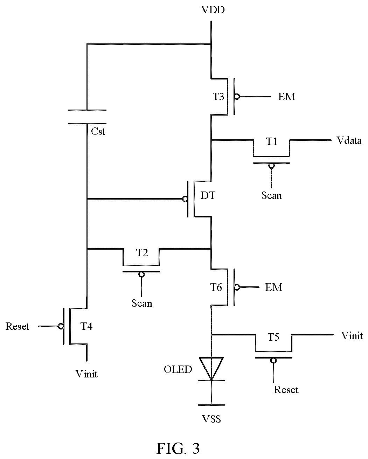

As shown in FIG. 3, the pixel circuit may include seven transistors and one storage capacitor, that is, a driving transistor DT, a first transistor T1 to a sixth transistor T6 and a storage capacitor Cst.

In the embodiment, the control end of the first transistor T1 can be used for receiving the writing control signal Scan, the first end of the first transistor T1 is used for receiving the data signal Vdata, and the second end of the first transistor T1 is connected to the first end of the driving transistor DT.

The control end of the second transistor T2 is used for receiving a writing control signal Scan, the first end of the second transistor T2 is connected to the second end of the driving transistor DT, and the second end of the second transistor T2 is connected to the control end of the driving transistor DT.

The control end of the third transistor T3 is used for receiving the light-emitting control signal EM, the first end of the third transistor T3 is used for receiving the first power supply signal VDD, and the second end of the third transistor T3 is connected to the first end of the driving transistor DT.

The control end of the fourth transistor T4 is used for receiving the reset control signal Reset, the first end of the fourth transistor T4 is used for receiving the reset signal Vinit, and the second end of the fourth transistor T4 is connected to the control end of the driving transistor DT.

The control end of the fifth transistor T5 is used for receiving the reset control signal Reset, the first end of the fifth transistor T5 is used for receiving the reset signal Vinit, and the second end of the fifth transistor T5 is connected to the first end of the light-emitting element OLED.

The control end of the sixth transistor T6 is used for receiving the light-emitting control signal EM, the first end of the sixth transistor T6 is connected to the second end of the driving transistor DT, and the second end of the sixth transistor T6 is connected to the first end of the light-emitting element OLED.

The first end of the storage capacitor Cst is connected to the first end of the third transistor T3, for inputting the first power supply signal VDD, and the second end of the storage capacitor Cst is connected to the control end of the driving transistor DT.

The above-mentioned driving transistor DT, the first transistor T1 to the sixth transistor T6 are all P-type thin film transistors. The first power supply signal VDD is a high-level signal, and the second power supply signal VSS is a low-level signal. The light-emitting element OLED is an organic light-emitting diode. The first end of the light-emitting element OLED is the anode of the organic light emitting diode, and the second end thereof is the cathode of the organic light emitting diode. The driving transistor DT, the first transistor T1 to the seventh transistor T6 are all turned on at a low level and turned off at a high level.

The driving method of the above-mentioned pixel circuit includes following stages.

In the reset stage, the fourth transistor T4 and the fifth transistor T5 are turned on, the first transistor T1, the second transistor T2, the third transistor T3 and the sixth transistor T6 are turned off, the reset signal Vinit is transmitted to the control end of the driving transistor DT and the first end of the light-emitting element OLED.

In the data writing stage, the first transistor T1 and the second transistor T2 are turned on, and the third transistor T3, the fourth transistor T4, the fifth transistor T5 and the sixth transistor T6 are turned off, so as to transmit the data signal Vdata to the control end of the driving transistor DT through the first transistor T1, the driving transistor DT and the second transistor T2.

In the light-emitting stage, the third transistor T3 and the sixth transistor T6 are turned on, and the first transistor T1, the second transistor T2, the fourth transistor T4 and the fifth transistor T5 are turned off, so as to transmit the signal of the second end of the driving transistor DT to the first end of the light-emitting element OLED, in order to control the light-emitting element OLED to emit light.

The above-mentioned driving circuit layer may include a plurality of thin film transistors and capacitors. The thin film transistors may be top gate or bottom gate thin film transistors. Each thin film transistor may include an active layer, a gate electrode, a source electrode and a drain electrode. The gate electrode can be a double gate electrode or a single gate electrode. The active layer of each thin film transistor is arranged in the same layer, the gate electrode of each thin film transistor is arranged in the same layer, and the source electrode and the drain electrode of each thin film transistor are arranged in the same layer, so as to simplify the process.

The following takes the driving transistor being a top-gate thin film transistor as an example, to illustrate the structure of the driving backplane 11.

The driving backplane 11 may include a substrate and a driving circuit layer on a side of the substrate. The driving circuit layer may include an active layer, a first gate insulating layer, a gate electrode, a second gate insulating layer, an interlayer dielectric layer, and a source-drain layer, and a flat layer. The active layer is arranged on a side of the substrate, the first gate insulating layer covers the active layer and the substrate. The gate electrode is arranged on the surface of the first gate insulating layer away from the substrate, and is directly opposite to the active layer. The second gate insulating layer covers the gate electrode and the first gate insulating layer. The interlayer dielectric layer covers the second gate insulating layer. The source-drain layer is arranged on the surface of the interlayer dielectric layer away from the substrate, and include a source electrode and a drain electrode. The source electrode and the drain electrode are connected to two ends of the active layer through contact holes. The flat layer covers the source-drain layer and the interlayer dielectric layer. The driving circuit layer may also include other film layers, as long as they can drive the light-emitting element to emit light, which will not be described in detail herein.

As shown in FIG. 1, the light-emitting layer 12 is disposed on the side of the driving backplane 11. For example, the light-emitting layer 12 is disposed on a surface of the flat layer away from the substrate. The light-emitting layer 12 is located within the range of the display area 101. The light-emitting layer 12 may include a plurality of light-emitting units distributed in an array. Each light-emitting unit includes a plurality of light-emitting elements.

In some embodiments of the present disclosure, the light-emitting element is an OLED, which may include a first electrode, a light-emitting functional layer, and a second electrode sequentially stacked along a direction away from the driving backplane 11.

In the embodiment, the first electrode can be located on the side of the flat layer away from the substrate, and is connected to the drain electrode of a thin film transistor of a pixel circuit through a contact hole. The thin film transistor can be a driving transistor or other transistors, depending on the structure of the pixel circuit, which will not be specially limited herein. The light-emitting functional layer may include a hole injection layer, a hole transport layer, a composite light-emitting layer, an electron transport layer, and an electron injection layer sequentially stacked in a direction away from the driving backplane 11. Further, an electron blocking layer may also be provided between the hole transport layer and the composite light-emitting layer. The second electrode can extend to the peripheral area 102 and be connected to the power supply signal terminal, to receive the power supply signal. The specific principle of emitting light of the OLED will not be described in detail herein.

As shown in FIG. 1, in order to facilitate defining the range of each light-emitting element, the light-emitting layer 12 may further include a pixel definition layer, which may be provided on the surface of the driving circuit layer away from the substrate together with the first electrode, and provided with a plurality of openings for exposing each first electrode in a one-to-one correspondence. The light-emitting functional layer is stacked on the region where the first electrode is located in the opening. The light-emitting functional layers of each light-emitting element are distributed at intervals independent of each other. The light-emitting colors of different light-emitting functional layers may be the same or different. The second electrode covers the light-emitting functional layer, so that each light-emitting element can share the same second electrode. Each light-emitting element can be defined by a plurality of openings described above. The boundary of any light-emitting element is the boundary of the light-emitting functional layer in the corresponding opening.

In other embodiments of the present disclosure, the light-emitting functional layer of each light-emitting element may belong to the same continuous light-emitting film layer. The light-emitting film layer simultaneously covers the surface of each first electrode and the pixel definition layer away from the substrate. The region where the light-emitting film layer is located in the opening and stacked on the first electrode is the light-emitting functional layer of the light-emitting element, and two adjacent light-emitting functional layers are connected through other regions of the light-emitting film layer. That is to say, each light-emitting element can share the light-emitting film layer.

In some embodiments of the present disclosure, each light-emitting unit may include a plurality of light-emitting elements with different light-emitting colors, and each light-emitting element emits monochromatic light or quasi-monochromatic light.

In addition, as shown in FIG. 2, the display panel 1 may further include an encapsulation layer 13, which may cover the surface of the light-emitting layer 12 away from the driving backplane 11 and cover all light-emitting elements, so as to protect the light-emitting layer 12 and prevent external water and oxygen from eroding the light-emitting element. At the same time, the boundary edge of the encapsulation layer 13 extends into the peripheral area 102, but does not exceed the peripheral area 102, which can also protect the peripheral circuits of the peripheral area 102.

In some embodiments of the present disclosure, thin-film encapsulation (TFE) may be used to realize encapsulation. The encapsulation layer 13 may include a first inorganic layer, an organic layer and a second inorganic layer. The first inorganic layer covers the surface of the light-emitting layer 12 away from the driving backplane 11. The organic layer can be disposed on the surface of the first inorganic layer away from the driving backplane 11, and the boundary of the organic layer is restricted to the inner side of the boundary of the first inorganic layer. The second inorganic layer covers the organic layer and the first inorganic layer not covered by the organic layer. The second inorganic layer can block the intrusion of water and oxygen, and the flexible organic layer can achieve the planarization.

As shown in FIG. 1 and FIG. 2, the protective layer 2 is disposed on a side of the display panel 1. For example, the protective layer 2 can be disposed on the side of the driving backplane 11 away from the light-emitting layer 12. Meanwhile, the protective layer 2 may cover at least a part of the peripheral area 102 and the display area 101. For example, the boundary of the protective layer 2 is located within the peripheral area 102 and has a specified distance from the boundary of the peripheral area 102.

The protective layer 2 may include a heat dissipation layer 21 to dissipate heat for the display panel 1. The material of the heat dissipation layer 21 may be copper or other metals with good thermal conductivity, or non-metallic materials such as graphene, etc. Due to the use of the material with high electrical conductivity, the heat dissipation layer 21 can conduct electricity at the same time.

Further, in some embodiments of the present disclosure, as shown in FIG. 2, the protective layer 2 may further include an adhesive layer 22, a buffer layer 23 and a reinforcement layer 24.

The buffer layer 23 can be adhered to the backlight side of the display panel 1, that is, the side of the driving backplane 11 away from the light-emitting layer 12, through the adhesive layer 22. The adhesive layer 22 may be mesh glue (EMBO), which is beneficial to exhausting gas while realizing the bonding, and if the display panel 1 is a flexible display panel 1, the mesh glue can adapt to the bending of the display panel 1. Other adhesives may also be used for the adhesive layer 22. The buffer layer 23 may be foam or other flexible materials, so as to play a role of buffering for the display panel 1 and also play a role of shielding light.

The reinforcing layer 24 can be disposed on the side of the buffer layer 23 away from the display panel 1. The reinforcing layer 24 can be used to improve the strength of the protective layer 2, so that it is not easy to be broken and damaged. The material of the reinforcing layer 24 can be polyimide or other flexible materials. However, if the display panel 1 is a flexible display panel 1, the reinforcing layer 24 should be a flexible material, so that the display panel 1 can be bent. The aforementioned heat dissipation layer 21 can be disposed on the surface of the reinforcing layer 24 away from the display panel 1.

As shown in FIG. 1 and FIG. 2, the cover plate 3 can be arranged on the side of the display panel 1 away from the protective layer 2, that is, the cover plate 3 is arranged on the side of the light-emitting layer 12 away from the driving backplane 11, to protect the display panel 1. The area of the cover plate 3 may be larger than that of the display panel 1, so that the edge of the cover plate 3 may protrude out of the edge of the display panel 1. The boundary of the edge area 312 may also coincide with the boundary of the peripheral area 102. The cover plate 3 can be a transparent structure, making the light emitted by the light-emitting layer 12 pass through.

In some embodiments of the present disclosure, at least a partial area of the edge of the cover plate 3 may be bent toward the side close to the protective layer 2, and both the display panel 1 and the protective layer 2 may be planar structures, and the bent area of the cover plate 3 is located outside the boundary of the protective layer 2 and the display panel. Alternatively, the edges of the display panel 1 and the protective layer 2 are also bent, and the bent area is fitted with the bent area of the cover plate 3.

Further, as shown in FIG. 1 and FIG. 2, the display module may further include a polarizer 5, which may be arranged between the encapsulation layer 13 and the cover plate 3. The polarizer 5 may be a circular polarizer, to reduce the reflection of the external light by the display module. An optical adhesive layer 6 can be provided between the polarizer 5 and the cover plate 3, and the optical adhesive layer 6 can be used to achieve planarization, so as to fit with the cover plate 3 and reduce the optical path difference at different positions.

In addition, the display module may further include a touch-control layer, which may be disposed between the encapsulation layer 13 and the cover plate 3. The orthographic projection of the touch-control layer on the display panel 1 at least covers the display area 101. The touch-control layer may adopt a self-capacitance or mutual-capacitance touch-control structure. For example, the touch-control layer may be plug-in, or may also be an On-Cell manner such as FMLOC (Flexible Multi-Layer On Cell). The specific structure is not specially limited herein, as long as the touch-control function can be realized. The user can operate on the side of the cover plate 3 away from the display panel 1, and sense the touch-control position through the touch-control layer, so as to realize interaction.

The display module can also include a light shielding layer 8, which can be arranged between the cover plate 3 and the display panel 1. The material of the light shielding layer 8 can be ink or opaque photoresist, etc. The orthographic projection of the light shielding layer 8 on the display panel 1 is located in the peripheral area 102 and is arranged around the display area 101. At least a part of the peripheral area 102 of the display panel 1 can be shielded by the light shielding layer 8.

The technical solution for improving the color cast of the display module according to the embodiment of the present disclosure will be described in detail below.

As shown in FIG. 1 and FIG. 2, since the heat dissipation layer 21 of the protective layer 2 is made of a metal material and has conductive properties, the cover plate 3 and the heat dissipation layer 21 can be electrically connected through the conductive medium 4, so as to guide out charges on the cover plate 3.

In some embodiments of the present disclosure, in order to facilitate guiding the charge, a conductive layer 32 may be provided in the cover plate 3, and a conductive path between the conductive layer 32 and the heat dissipation layer 21 may be established. When the heat dissipation layer 21 is grounded, the charges accumulated on the conductive layer 32 can be conducted to the heat dissipation layer 21, and finally guided to a preset grounding terminal connected to the heat dissipation layer 21, to avoid interference to the pixel circuit. Specifically, the cover plate 3 may include a transparent base 31 and a conductive layer 32.

In the embodiment, the transparent base 31 has a middle area 311 and an edge area 312 located outside the middle area 311. The middle area 311 covers the display area 101, and the boundary of the middle area 311 may coincide with the boundary of the display area 101. The edge area 312 may cover the peripheral area 102, and the boundary of the edge area 312 may be located outside the peripheral area 102, that is, the area of the transparent base 31 may be larger than that of the display panel 1, such that the edge of the transparent base 31 may extend beyond the edge of the display panel 1. The boundary of the edge area 312 may also coincide with the boundary of the peripheral area 102. The material of the transparent base 31 can be a transparent material such as glass, which is not particularly limited herein.

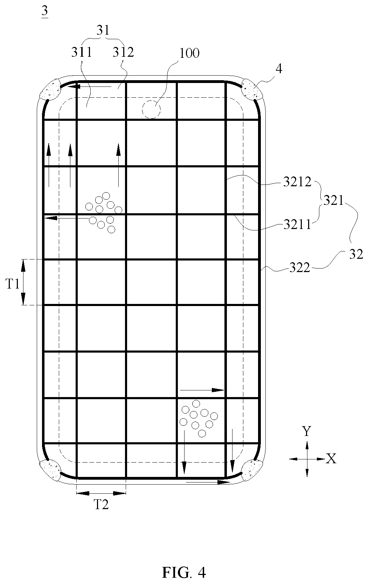

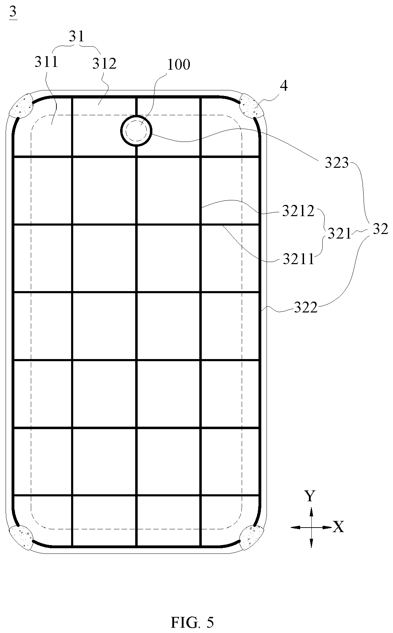

As shown in FIG. 4 and FIG. 5, the conductive layer 32 is disposed on the surface of the transparent base 31 away from the display panel 1 and is connected to the heat dissipation layer 21. The conductivity of the material of the conductive layer 32 is higher than that of the transparent base 31, and the conductivity of the conductive layer 32 can be 10 times, 20 times, 100 times, etc. of that of the transparent base 31, which is not particularly limited herein. For example, the material of the conductive layer 32 may include a transparent conductive material such as ITO (indium tin oxide), which can avoid blocking light while ensuring the conductivity. The material of the conductive layer 32 may also include other transparent conductive materials such as IZO (indium zinc oxide), which will not be listed one by one herein. In addition, the conductive layer 32 can also use other conductive materials, as long as it does not affect the image display and can conduct electricity.

The conductive layer 32 may include a middle wire 321 located in the middle area 311. That is, the orthographic projection of the middle wire 321 on the display panel 1 is located in the display area 101, so as to conduct charges in the display area 101 to the heat dissipation layer 21. When in use, the heat dissipation layer 21 can be grounded, that is, the potential of the heat dissipation layer 21 can be set to 0, so as to guide the charges of the conductive layer 32 to transfer to the heat dissipation layer 21, and finally guide to a preset grounding terminal. The grounding terminal can be grounded through the grounding terminal of the electronic equipment using the display module of the present disclosure. The conductive layer 32 can be a continuous planar film layer, as long as the charges can be guided out.

In some embodiments of the present disclosure, as shown in FIG. 1, at least a partial area of the edge of the cover plate 3 is bent toward a direction close to the protective layer 2. At this time, at least a partial area of the edge area 312 of the transparent base 31 can be bent toward the direction close to the protective layer 2, and the middle area 311 is a planar structure.

The structure of the conductive layer 32 will be described below.

As shown in FIG. 4 and FIG. 5, the number of the middle wires 321 is plural, and they intersect with each other to form a grid structure. In some embodiments of the present disclosure, the middle wires 321 may include first middle wires 3211 and second middle wires 3212 extending in a straight line. The first middle wires 3211 may extend in a row direction and be spaced apart in a column direction. The second middle wires 3212 extend along the column direction and are spaced apart along the row direction. Each of the second middle wires 3212 is arranged to intersect with each of the first middle wires 3211. The row direction may be the X direction as shown in FIG. 4 and FIG. 5, and the column direction may be the Y direction as shown in FIG. 4 and FIG. 5, and they are perpendicular to each other.

It should be noted that the row direction and column direction in FIG. 4 and FIG. 5 are only illustrative, which does not constitute a specific limitation on the middle wire 321. Those skilled in the art can know that if the row direction and column direction are rotated, thy will change accordingly.

As shown in FIG. 4 and FIG. 5, both the distance T1 between two adjacent first middle wires 3211 and the distance T2 between two adjacent second middle wires 3212 can be 1cm-3cm, such as 1cm, 2cm or 3cm, etc. However, T1 and T2 can be different. The distance between two adjacent first middle wires 3211 may be the sum of the width of the gap between two adjacent first middle wires 3211 and the line width of one first middle wire 3211, that is, the distance between centerlines of two adjacent first middle wires 3211. Similarly, the distance between two adjacent second middle wires 3212 may be the sum of the width of the gap between two adjacent second middle wires 3212 and the line width of one second middle wire 3212, that is, the distance between centerlines of two adjacent second middle wires 3212.

In some embodiments of the present disclosure, for a rectangular display module, if the first direction is the width direction and the second direction is the length direction; if the aspect ratio of the display module is 16:9, eight first middle wires 3211 and four second middle wires 3212 can be arranged. The distance between two adjacent middle wires 321 is 2 cm.

As shown in FIGS. 4 and 5, in order to facilitate the connection of the middle wires 321 with the heat dissipation layer 21, in some embodiments of the present disclosure, the conductive layer 32 further includes an edge wire 322. The edge wire 322 is located in the edge area 312 of the transparent base 31, and the edge wire 322 is arranged around the middle area 311. Each of the middle wires 321 is connected with the edge wire 322, and the edge wire 322 can be connected with the heat dissipation layer 21.

In some embodiments of the present disclosure, the edge wire 322 may be a closed annular structure, and is disposed in the edge area 312 and surrounds outside the middle area 311. Two ends of each middle wire 321 are connected with the edge wires 322. The annular structure may be a circular ring, a rectangular ring, etc., and its shape may be the same as that of the middle area 311, depending on the shape of the middle area 311. Meanwhile, the edge wire 322 is connected with the heat dissipation layer 21. In other embodiments of the present disclosure, the edge wire 322 may also be a "U" shape or other incompletely closed bent structure, which may surround outside the middle area 311, but not completely enclose the middle area 311.

In addition, as shown in FIG. 5, the display area 101 of the display panel 1 may be provided with an opening 100. The opening 100 may penetrate through the light-emitting layer 12 and the driving circuit layer of the display panel 1 and expose the substrate. The opening 100 may also penetrate through the substrate. On the side of the protective layer 2 away from the display panel 1, a camera device corresponding to the opening 100 can be provided, so that an image can be captured through the display module. Correspondingly, the conductive layer 32 further includes an avoidance wire 323. An orthographic projection of the avoidance wire 323 on the display panel 1 at least partially surrounds outside the opening 10, and the avoidance wire 323 is connected with at least one of the middle wires 321. When the opening 100 is located on the extending path of a middle wire 321, the opening 100 can be bypassed by the avoidance wire 323, such that the middle wire 321 is connected with the edge wire 322, or directly connected with the heat dissipation layer 21.

In some embodiments of the present disclosure, as shown in FIG. 5, the avoidance wire 323 may be a closed annular structure, and surrounds outside the opening 100. One middle wire 321 is connected with the avoidance wire 323, and the avoidance wire 323 can divide the middle wire 321 into two sections and they are connected by the avoidance wire 323. The middle wire 321 may be the first middle wire 3211 or the second middle wire 3212, which is not limited herein.

The connection manner between the conductive layer 32 and the heat dissipation layer 21 will be described below.

As shown in FIG. 1, FIG. 4, FIG. 5 and FIG. 7, the conductive layer 32 and the heat dissipation layer 21 can be electrically connected through the conductive medium 4. The conductive medium 4 can be electrically connected with the conductive layer 32 on the surface of the transparent base 31 away from the protective layer 2. The conductive medium 4 is electrically connected with the edge of the heat dissipation layer 21 across the edge of the display panel 1 and the edge of the transparent base 31 from an outer side of the edge of the display panel 1 and the edge of the transparent base 31.

The conductive medium 4 can be conductive adhesive or other materials that connect the conductive layer 32 and the heat dissipation layer 21, which is not particularly limited herein. For example, the conductive adhesive may include a matrix and a conductive filler. The matrix may include epoxy resin, acrylate resin, polychlorinated ester, and the like. The part by weight of the matrix in the conductive adhesive may be 15%-25%. The conductive filler may include metal powders such as gold, silver, copper, aluminum, zinc, iron, nickel, etc., and may also include graphite or other conductive compounds. The part by weight of the conductive filler in the conductive adhesive may be 30%-60%. In addition, the conductive adhesive may further include a solvent, and an auxiliary agent, etc. The solvent may be a compound such as water and alcohol. The part by weight of the solvent in the conductive adhesive may be 10%-20%. The auxiliary agent can be a cross-linking agent, a coupling agent and the like.

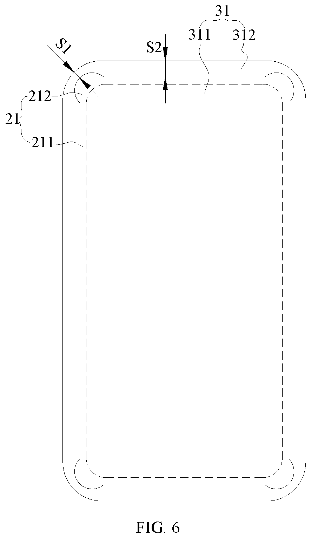

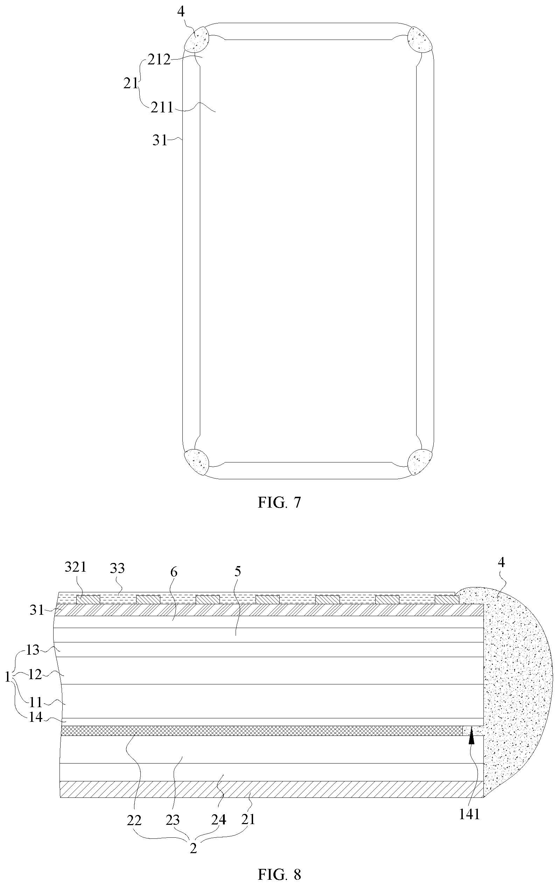

In some embodiments of the present disclosure, as shown in FIGS. 6 and 7, the boundary of the heat dissipation layer 21 is located inside the boundary of the transparent base 31, so that the area of the heat dissipation layer 21 is smaller than that of the transparent base 31. Meanwhile, the heat dissipation layer 21 includes a main body area 211 and a connection area 212 located outside the main body area 211. The number of connection areas 212 can be one or more. The boundary of the orthographic projection of the main body area 211 on the transparent base 31 may be located within the peripheral area 102. That is, the range of the main body area 211 is not smaller than the middle area 311, and the boundary of the orthographic projection of the connection area 212 on the transparent base 31 is also located within the edge area 312. For example, the shape of the main body area 211 can be a rectangular structure with four rounded corners, and the connection area 212 can be an arc-shaped region located at the four corners of the rectangle and protruding outward.

The connection area 212 is connected with the main body area 211, and the connection area 212 is connected with the conductive layer 32 through the conductive medium 4. Since the connection area 212 is located outside the main body area 211, the connection area 212 is closer to the edge of the transparent base 31 than the middle area 311. Without adding the conductive medium 4, the connection area 212 can increase the contact surface between the conductive medium 4 and the heat dissipation layer 21, shorten the extending path of the conductive medium 4, make the contact more sufficient and the connection more stable, and facilitate the sufficient conduction of the heat dissipation layer 21 and the conductive layer 32.

Further, as shown in FIG. 6, in the direction parallel to the middle area 311, a distance between a boundary of an orthographic projection of the connection area 212 on the transparent base 31 and the boundary of the transparent base 31 is defined as a first distance S1, and a distance between a boundary of an orthographic projection of the main body area 212 on the transparent base 31 and the boundary of the transparent base 31 is defined as a second distance S2. The first distance S1 is less than the second distance S2. That is, the distance between the connection area 212 and the boundary of the transparent base 31 is smaller than the distance between the main body area 211 and the boundary of the transparent base 31. The boundary of the orthographic projection of the connection area 212 on the transparent base 31 is arc-shaped, and the first distance S1 is the distance between the arc and the boundary of the transparent base 31 at the closest point. For example, the first distance S 1 may be 0.3mm-0.5mm, such as 0.3mm, 0.4mm or 0.5mm, etc. The second distance S2 may be 0.9mm-1.1 mm, such as 0.9mm, 1mm or 1.1mm, etc.

In addition, in some embodiments of the present disclosure, as shown in FIG. 1, the cover plate 3 may further include an isolation layer 33, which may cover at least a part of the transparent base 31 and the conductive layer 32. The isolation layer 33 is made of a transparent insulating material, and used to protect the conductive layer 32 and the transparent base 31 from being worn and corroded. At the same time, the user can perform touch-control operations on the side of the isolation layer 33 away from the display panel 1. Therefore, the isolation layer 33 can be made of an anti-finger material to avoid forming fingerprints. For example, the isolation layer 33 can be made of an oleophobic material. Once the oil stains on the fingers touch the isolation layer 33, tiny oil droplets will be formed to avoid forming fingerprint patterns.

The boundary of the orthographic projection of the isolation layer 33 on the transparent base 31 may be located within the edge area 312 so as to completely cover the middle area 311 and at least partially cover the edge area 312. Further, the boundary of the orthographic projection of the isolation layer 33 on the transparent base 31 can be coincident with the boundary of the transparent base 31, so as to completely cover the conductive layer 32 and the transparent base 31 not covered by the conductive layer 32.

If the isolation layer 33 completely covers the middle wire 321 and the edge wire 322, in order to ensure that the conductive medium 4 can be connected with the edge wire 322, in some embodiments of the present disclosure, via holes exposing the edge wire 322 may be provided on the isolation layer 33, the conductive medium 4 may extend from the surface of the isolation layer 33 away from the transparent base 31 into the via hole, so as to be connected with the edge wire 322. Alternatively, in some embodiments of the present disclosure, before forming the isolation layer 33, the edge wire 322 may be connected with the heat dissipation layer 21 through the conductive medium 4, and then the conductive layer 32, the conductive medium 4 and the transparent base 31 may be covered by the isolation layer 33.

In other embodiments of the present disclosure, the boundary of the isolation layer 33 coincides with the boundary of the middle area 311, so that the edge wire 322 is not covered by the isolation layer 33. At this time, the edge wire 322 can be directly connected with the heat dissipation layer 21 through the conductive medium 4.

The specific principles of preventing charge accumulation and improving color cast by the display module of the present disclosure will be described in detail below.

During the repeated friction process of the copper rod test, electrons are gradually transferred from the copper rod to the surface of the cover plate 3, and negative charge accumulation is formed in the local part of the cover plate 3. At the same time, due to the friction, the local part of the cover plate 3 will lose electrons, which is equivalent to that positive charges are accumulated on the local part of the cover plate 3.

Due to the path formed by the conductive layer 32 and the heat dissipation layer 21, and the charges tend to accumulate in materials with higher conductivity, the charges on the cover plate 3 reach the nearby middle wire 321 in the closest manner and at the first time. After the charges are accumulated on the middle wire 321, a potential difference is formed with respect to the grounded heat dissipation layer 21, and the charges move along the conductive medium 4 to the heat dissipation layer 21 under the action of the electric field Coulomb force, and is finally conducted from the heat dissipation layer 21 to the grounded point of the driving circuit board. In this process, the accumulation of charges on the cover plate 3 is eliminated, and the interference to the thin film transistor of the pixel circuit is avoided, so that abnormal display phenomena such as color cast can be improved.

Further, in another embodiment of the present disclosure, as shown in FIG. 8, the orthographic projection of the connection area 212 of the heat dissipation layer 21 on the transparent base 31 is at least partially located in the edge area 312. The display module further includes a light shielding layer 8, which can be disposed on the surface of the transparent base 31 close to the display panel 1 and in the edge area 312. The light shielding layer 8 is a conductive light-shielding material. For example, the light shielding layer 8 can be made of conductive black ink. Other materials can also be used, as long as they can block light and conduct electricity.

At least a partial area of the connection area 212 can be electrically connected with the light shielding layer 8 so as to guide out the charges on the transparent base 31. For example, at least a partial area of the connection area 212 can be bent toward the direction close to the transparent base 31 and be directly connected to the light shielding layer 8, and can be electrically connected through conductive adhesive or other media. The aforementioned conductive medium 4 may be connected with the light shielding layer 8 and the connection area 212 at the same time, or may only be connected with the connection area 212 without being connected with the light shielding layer 8.

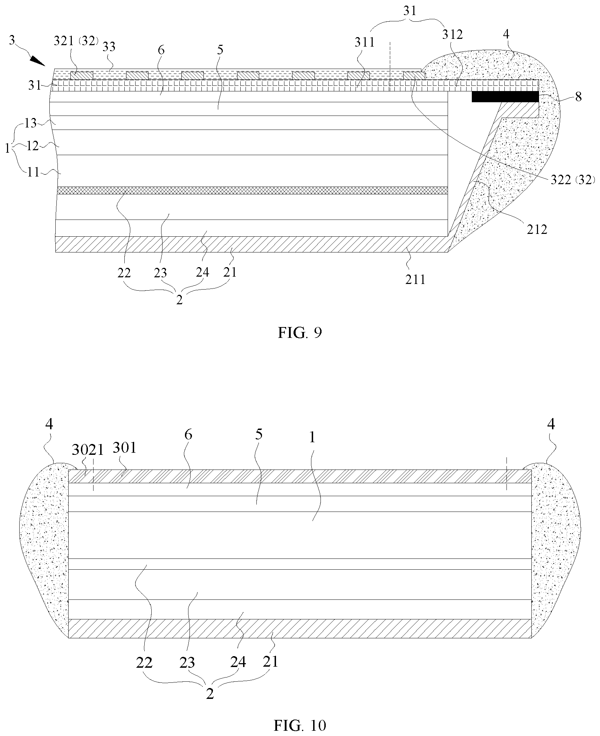

In yet another embodiment of the present disclosure, as shown in FIG. 9, the surface of the driving backplane 11 away from the light-emitting layer 12 may cover the back film 14 for protecting the driving backplane 11, and the boundary of the back film 14 may coincide with the boundary of the driving backplane 11. The material of the back film 14 may be resin or other materials, and it may be a multi-layer or single-layer structure. The adhesive layer 22 can be bonded to the surface of the back film 14 away from the light-emitting layer 12, and the boundary of the adhesive layer 22 is located within the boundary of the back film 14. There is a spacer area 141 between the boundary of the back film 14 and the adhesive layer 22. The spacer area 141 is the area of the back film 14 not covered by the adhesive layer 22.

While electrically connecting the conductive layer 32 and the heat dissipation layer 21, the conductive medium 4 also extends to a region corresponding to the spacer area 141 and is electrically connected with the spacer area 141, thereby guiding out the charges on the back film 14.

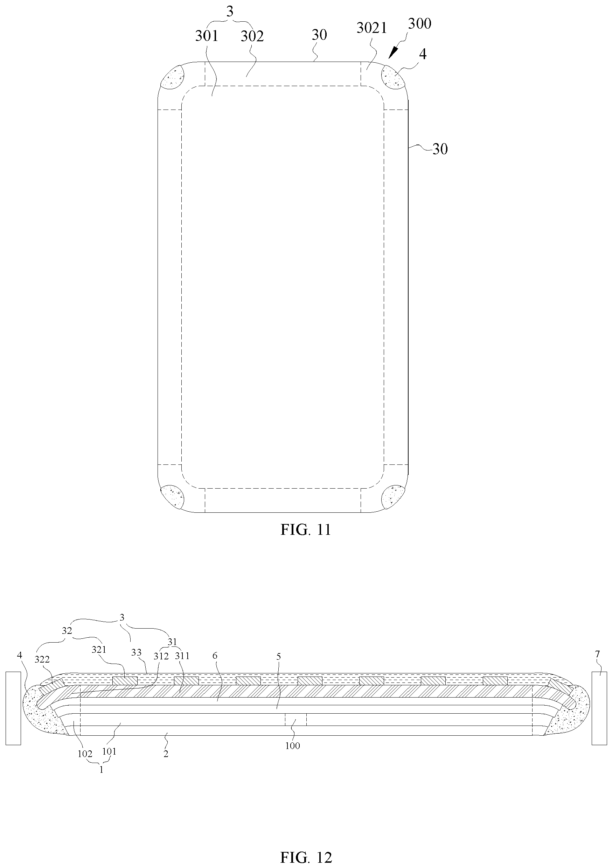

As shown in FIG. 10 and FIG. 11, in some embodiments of the present disclosure, charges can also be channeled without the above conductive layer 32. For example, the cover plate 3 is made of a transparent material and does not include the above conductive layer 32. The cover plate 3 may have a body area 301 and a surrounding area 302 outside the body area 301. The body area 301 covers the display area 101, the surrounding area 302 covers the peripheral area 102. The conductive medium 4 connects the surrounding area 302 and the heat dissipation layer 21. The charges on the cover plate 3 can also be directed to the heat dissipation layer 21 through the conductive medium 4.

Further, there may be a plurality of contact positions between the conductive medium 4 and the surrounding area 302. For example, the surrounding area 302 includes a plurality of contact areas 3021 spaced apart along a circumferential direction of the body area 301. The conductive medium is connected with the contact areas 3021.

Further, the outer peripheral surface of the cover plate 3 can be surrounded by a plurality of side surfaces 30 distributed in the circumferential direction. The connection between two adjacent side surfaces 30 is a corner 300. The number of the side surfaces 30 is not particularly limited herein, which can be three, four, five, etc. The two adjacent side surfaces 30 can be directly connected, or can be transitionally connected by an arc, such that the orthographic projection of the cover plate 3 on the display panel 1 is a polygon or a polygon with arc angles. Any corner 300 is located in a contact area 3021, and each contact area 3021 has a corner 300. The conductive medium 4 connected with a contact area 3021 covers the corner 300 in the contact area 3021. That is, each corner 300 of the cover plate 3 is covered with the conductive medium 4.

Embodiments of the present disclosure provide a method for manufacturing a display module. The display module can be the display module of any of the above-mentioned embodiments, and its specific structure will not be repeated herein. The manufacturing method of the present disclosure may include steps S110-S140, wherein:
step S110, forming a display panel, wherein the display panel has a display area and a peripheral area located outside the display area;
step S120, forming a cover plate on a side of the display panel;
step S130, forming a protective layer on a side of the display panel away from the cover plate, wherein the protective layer covers at least a part of the peripheral area and the display area; the protective layer includes a conductive heat dissipation layer; and
step S140, connecting the cover plate and the heat dissipation layer electrically through a conductive medium.

The details of the structures involved in each step of the manufacturing method of the present disclosure have been described in detail in the embodiments of the display module, which will not be repeated herein. In the embodiment, the step S 140 may include:
forming a conductive material connecting the heat dissipation layer across an edge of the display panel through an outer side of the edge of the display panel;
curing the conductive material to obtain the conductive medium.

It should be noted that although the various steps of the manufacturing method of the present disclosure are described in a specific order in the drawings, this does not require or imply that the steps must be performed in this specific order, or that all of the steps shown must be performed to achieve the desired result. Additionally or alternatively, certain steps may be omitted, a plurality of steps may be combined into one step for execution, and/or one step may be decomposed into a plurality of steps for execution, and the like.

Embodiments of the present disclosure further provide a display device, which may include the display module of any of the above-mentioned embodiments. For the specific structure and beneficial effects of the display module, reference may be made to the above-mentioned embodiments of the display module, which will not be described in detail herein.

In addition, as shown in FIG. 12, the display device may further include a frame 7. The display module may be placed in the range surrounded by the frame 7, and the display module may be protected by the frame 7.

The display device may further include a driving circuit board, which may be a flexible circuit board. It can be connected with the display panel 1 and bent to the side of the protective layer 2 away from the cover plate 3. Driving signals can be output to the display panel 1 through the driving circuit board to display images. At the same time, the heat dissipation layer 31 can also be connected with the driving circuit board, so that the heat dissipation layer 31 can be grounded through the driving circuit board, so as to dissipate the charges accumulated on the conductive layer 32.

The display device of the present disclosure may be a mobile phone, a tablet computer, a wearable device (smart bracelet, a watch), a notebook computer, a TV, or other similar devices with an image display function, which will not be listed herein.

Other embodiments of the present disclosure will readily occur to those skilled in the art upon consideration of the specification and practice of the disclosure disclosed herein. This disclosure is intended to cover any variations, uses, or adaptations of this disclosure that follow the general principles of this disclosure and include common general knowledge or conventional technical means in the technical field not disclosed by this disclosure. The specification and embodiments are to be regarded as exemplary only, with the true scope and spirit of the disclosure being indicated by the appended claims.

## Claims

1. A display module, comprising:
a display panel, having a display area and a peripheral area located outside the display area;
a protective layer, disposed on a side of the display panel, wherein the protective layer covers at least a part of the peripheral area and the display area; and the protective layer comprises a conductive heat dissipation layer;
a cover plate, disposed on a side of the display panel away from the protective layer; and
a conductive medium, wherein the cover plate is electrically connected with the heat dissipation layer through the conductive medium.

2. The display module according to claim 1, wherein the cover plate comprises a transparent base and a conductive layer, the transparent base has a middle area and an edge area located outside the middle area; the middle area covers the display area, the edge area covers the peripheral area; the conductive layer is disposed on a surface of the transparent base away from the display panel and is electrically connected with the heat dissipation layer through the conductive medium, the conductive layer at least comprises a middle wire located in the middle area.

3. The display module according to claim 2, wherein the conductive layer further comprises an edge wire, the edge wire is located in the edge area and is disposed around the middle area; each middle wire is connected with the edge wire, and the edge wire is connected with the heat dissipation layer.

4. The display module according to claim 3, wherein a quantity of the middle wire is plural and the plurality of middle wires intersect with each other to form a grid structure.

5. The display module according to claim 4, wherein the middle wires comprise first middle wires and second middle wires, the first middle wires extend along a row direction and are spaced apart along a column direction; the second middle wires extend along the column direction and are spaced apart along the row direction; the second middle wires intersect with the first middle wires.

6. The display module according to claim 4, wherein the display area is provided with an opening, the conductive layer further comprises an avoidance wire, an orthographic projection of the avoidance wire on the display panel at least partially surrounds outside the opening; the avoidance wire is connected to at least one of the middle wires.

7. The display module according to any one of claims 2-6, wherein the conductive medium connects the conductive layer and the heat dissipation layer across an edge of the display panel from an outer side of the edge of the display panel.

8. The display module according to claim 2, wherein a boundary of the heat dissipation layer is located inside a boundary of the transparent base, the heat dissipation layer comprises a main body area and a connection area located outside the main body area, the connection area is connected with the main body area;
the connection area is connected with the conductive layer through the conductive medium.

9. The display module according to claim 8, wherein, in a direction parallel to the main body area, a distance between a boundary of an orthographic projection of the connection area on the transparent base and the boundary of the transparent base is a first distance;
in a direction parallel to the main body area, a distance between a boundary of an orthographic projection of the main body area on the transparent base and the boundary of the transparent base is a second distance;
the first distance is smaller than the second distance.

10. The display module according to any one of claims 2-6, wherein the cover plate further comprises:
an isolation layer, at least covering the middle wire, wherein the isolation layer is made of a transparent insulating material.

11. The display module according to any one of claims 2-6, wherein the edge area of the transparent base is bent toward a side close to the protective layer.

12. The display module according to any one of claims 2-6, wherein the protective layer further comprises:
an adhesive layer, disposed on a side of the display panel away from the cover plate;
a buffer layer, adhered to a surface of the adhesive layer away from the cover plate;
a reinforcing layer, disposed on a surface of the buffer layer away from the cover plate,
wherein the heat dissipation layer is disposed on a surface of the reinforcing layer away from the cover plate.

13. The display module according to claim 8, wherein an orthographic projection of the connection area on the transparent base is at least partially located in the edge area;
the display module further comprises:
a light shielding layer, disposed on a surface of the transparent base close to the display panel and located in the edge area; the light shielding layer is made of a conductive material;
at least a part of the connection area is electrically connected with the light shielding layer.

14. The display module according to claim 13, wherein the display panel comprises:
a driving backplane;
a light-emitting layer, disposed on a side of the driving backplane away from the protective layer;
a back film, disposed on a surface of the driving backplane away from the light-emitting layer;
wherein the adhesive layer is adhered to a surface of the back film away from the light-emitting layer; a boundary of the adhesive layer is located within a boundary of the back film, and a spacer area exists between the boundary of the adhesive layer and the boundary of the back film;
the conductive layer is electrically connected with the heat dissipation layer through the conductive medium, and the conductive medium connects the conductive layer and the heat dissipation layer across an edge of the display panel from an outer side of the edge of the display panel;
the conductive medium is electrically connected with the spacer area.

15. The display module according to claim 1, wherein the cover plate has a main body area and a surrounding area located outside the main body area; the main body area covers the display area, and the surrounding area covers the peripheral area, the conductive medium is connected to the surrounding area;
the conductive medium connects the cover plate and the heat dissipation layer across an edge of the display panel from an outer side of the edge of the display panel.

16. The display module according to claim 15, wherein the surrounding area comprises a plurality of contact areas spaced apart along a circumferential direction of the main body area, and the conductive medium is connected to the contact areas.

17. The display module according to claim 16, wherein an outer peripheral surface of the cover plate is surrounded by a plurality of side surfaces distributed in a circumferential direction, and a junction between two adjacent side surfaces is a comer; any of the corners is located within one of the contact areas; the conductive medium connected to any of the contact areas covers the corner in the contact area.

18. A method for manufacturing a display module, comprising:
forming a display panel, wherein the display panel has a display area and a peripheral area located outside the display area;
forming a cover plate on a side of the display panel;
forming a protective layer on a side of the display panel away from the cover plate, wherein the protective layer covers at least a part of the peripheral area and the display area; the protective layer comprises a conductive heat dissipation layer;
connecting the cover plate and the heat dissipation layer electrically through a conductive medium.

19. The manufacturing method according to claim 18, wherein connecting the cover plate and the heat dissipation layer electrically through a conductive medium comprises:
forming a conductive material connecting the heat dissipation layer across an edge of the display panel through an outer side of the edge of the display panel;
curing the conductive material to obtain the conductive medium.

20. A display device, comprising the display module according to any one of claims 1-17.
